(19) Europäisches Patentamt
European Patent Office
Office européen des brevets

(11) Veröffentlichungsnummer: **0 325 319 B1**

(12) **EUROPÄISCHE PATENTSCHRIFT**

(45) Veröffentlichungstag der Patentschrift: **06.10.93**

(51) Int. Cl.⁵: **C23C 16/44**, C23C 16/18

(21) Anmeldenummer: **89200058.9**

(22) Anmeldetag: **11.01.89**

(54) **Verfahren zum Erzeugen eines mit dem Dampf eines wenig flüchtigen Stoffes angereicherten Gasstroms.**

(30) Priorität: **16.01.88 DE 3801147**

(43) Veröffentlichungstag der Anmeldung:
**26.07.89 Patentblatt 89/30**

(45) Bekanntmachung des Hinweises auf die Patenterteilung:
**06.10.93 Patentblatt 93/40**

(84) Benannte Vertragsstaaten:
**DE FR GB NL**

(56) Entgegenhaltungen:
DE-A- 3 136 895
DE-B- 1 221 520
FR-A- 2 554 131

PATENT ABSTRACTS OF JAPAN, Band 5, Nr. 67 (C-53)[739], 07 Mai 1981; JP-A-56 17 946 (ISHIZUKA GLASS K.K.) 20-02-1981

(73) Patentinhaber: **Philips Patentverwaltung GmbH**
**Wendenstrasse 35c**
**D-20097 Hamburg(DE)**

(84) Benannte Vertragsstaaten:
**DE**

(73) Patentinhaber: **N.V. Philips' Gloeilampenfabrieken**
**Groenewoudseweg 1**
**NL-5621 BA Eindhoven(NL)**

(84) Benannte Vertragsstaaten:
**FR GB NL**

(72) Erfinder: **Gärtner, Georg, Dr.**
**Martelenberger Weg 16B**
**D-5100 Aachen(DE)**
Erfinder: **Janiel, Peter**
**Otto-Dix-Strasse 1**
**D-5102 Würselen(DE)**
Erfinder: **Rau, Hans, Dr.**
**Brunnenstrasse 11**
**D-5100 Aachen(DE)**

(74) Vertreter: **Koch, Ingo, Dr.-Ing. et al**
**Philips Patentverwaltung GmbH,**
**Wendenstrasse 35c**
**D-20097 Hamburg (DE)**

## Beschreibung

Die Erfindung betrifft ein Verfahren zum Erzeugen eines mit dem Dampf mindestens eines Wenig flüchtigen, in Pulverform vorliegenden Stoffes angereicherten, aus mindestens einem Inertgas bestehenden Gasstroms, unter Verwendung einer Vorrichtung
- mit einem Gefäß mit einem Innenraum zur Aufnahme des Pulvers,
- einer Zuleitung für den Gasstrom und
- einer Ableitung für den angereicherten Gasstrom in einen Beschichtungs-Reaktor, in welchem ein niedrigerer Druck als im Gefäß herrscht,
- wobei in der Zuleitung und in der Ableitung je ein Ventil angeordnet ist,
- die Leitungen derart in das Gefäß münden, daß der Gasstrom bei Betrieb der Vorrichtung durch das Pulver hindurchströmt,
- das Gefäß und die Ableitung in einem Thermostaten angeordnet sind,
- das Pulver eine zusätzliche feste Inertkomponente enthält und
- der Innenraum zwei quer zum Gasstrom angeordnete Wände aus gasdurchlässigen, porösen Platten aufweist, während die übrigen Wände des Innenraums gasundurchlässig sind.

Vorrichtungen dieser Art, die nachstehend auch als Pulververdampfer, Pulversättiger oder Sättiger bezeichnet werden, dienen der Einstellung definierter Gasströme wenig flüchtiger Stoffe, die z.B. als Ausgangsverbindungen für reaktive Abscheidungen aus Gasphasen (CVD = Chemical Vapour Deposition) verwendet werden. Da handelsübliche Massenfluß-Regelventile normalerweise einen Differenzdruck von etwa 300 hPa benötigen, sind sie nur für Stoffe mit Dampfdrücken von mindestens 300 hPa bei Temperaturen unterhalb 90 °C einsetzbar.

Zur Erhöhung des Dampfdrucks bei wenig flüchtigen Ausgangsstoffen für CVD werden in der Regel metallorganische Verbindungen (MOV) der abzuscheidenden Metallkomponente verwendet. Üblicherweise erfolgt die Verdampfung aus der flüssigen Phase der MOV oder aus einer Lösung der MOV etwa bei Atmosphärendruck. Das führt erstens zu niedrigen Überführungsraten und zweitens zu einer zeitlichen Abnahme des Flusses wegen zunehmender Instabilität jenseits des Schmelzpunkts und/oder drittens zu einer Mitüberführung des Lösungsmittels. Daher beschäftigt die Erfindung sich unter anderem mit einem bei niedrigem Druck arbeitenden Pulververdampfer für metallorganische Ausgangsverbindungen, der die Probleme behebt, die bei Flüssigverdampfern für MOV auftreten, die etwa bei Normaldruck betrieben werden.

Die Probleme, die bei wenig flüchtigen Ausgangsstoffen auftreten, seien am Beispiel Thorium erläutert. Es gibt keine Thoriumverbindungen, die bei Zimmertemperatur Dampfdrücke von 300 hPa aufweisen. So erreichen z.B. die Thoriumhalogenide, die bei CVD-Verfahren normalerweise in Frage kämen, Dampfdrücke von 10 hPa erst bei Temperaturen von 600 °C bis 700 °C. Bestimmte metallorganische Thoriumverbindungen erreichen etwa 1 hPa bei etwa 150 °C, haben unterhalb ihres Schmelzpunkt eine noch ausreichende Stabilität, sind wasserfrei und können in Pulverform verwendet werden. So hat z.B. Thoriumheptafluordimethyloctandionat $(Th(fod)_4)$ bei 140 °C einen Dampfdruck von 0,13 hPa, während Thoriumtrifluoracetylacetonat $(Th(tfa)_4)$ bei derselben Temperatur einen Dampfdruck von 1,3 hPa hat. Sehr viel höher können diese Verbindungen nicht erhitzt werden, da dann schon ihre Zersetzung beginnt.

Eine der wichtigsten Voraussetzungen für die Verwendbarkeit von wenig flüchtigen pulverförmigen Ausgangsstoffen bei der reaktiven Abscheidung von Schichten aus einer Gasphase bei niedrigen Drücken (LPCVD = Low Pressure CVD) ist die Erzielung eines ausreichend großen und konstanten Massenflusses dieser Stoffe über längere Beschichtungsdauern, die gerade bei einem wenig flüchtigen Stoff notwendig sind. Fast alle bekannten Pulversättiger sowie auch Flüssigverdampfer mit nicht mehr ausreichend stabilen MOV zeigen eine relativ starke Abnahme ihrer Wirksamkeit und des Flusses, obwohl noch mengenmäßig bei weitem ausreichend viel Material zur Verdampfung und zum Transport zum CVD-Reaktor vorhanden ist.

Eine Verfahren der eingangs genannten Art ist aus DE-C-1 221 520 bekannt. Sie weist ein Verdampfergefäß auf, innerhalb dessen sich ein Sieb befindet, auf dem bei Betrieb der Vorrichtung der pulverförmige, wenig flüchtige Stoff in Form einer Pulverschüttung liegt. Von einem Inertgas-Vorratsbehälter führt eine Zuleitung zum Verdampfergefäß, in das die Zuleitung unterhalb des Siebes mündet. Vom Innenraum des Verdampfergefäßes oberhalb des Siebes führt eine Dampfableitung zu einem Reaktor, in dem eine Gasplattierung stattfindet, in dem also ein CVD-Verfahren durchgeführt wird.

Ein weiterer Pulververdampfer, in dessen Zuleitung und Ableitung je ein als Rückschlag- bzw. Sicherheitsventil ausgebildetes Ventil angeordnet ist, ist aus DE-A-3 136 895 bekannt. Aus einer darin genannten Formel folgt, daß der Massenfluß (dort Dampfdurchfluß genannt) um so größer ist, je niedriger der Gesamtdruck ist. Nach einer darauffolgenden Näherung entspricht der Gesamtdruck dem Ansprechdruck; die niedrigsten Ansprechdifferenzdrucke liegen aber bei handelsüblichen Rückschlagventilen bei etwa 30

EP 0 325 319 B1

hPa, so daß der Gesamtdruck nicht kleiner als 30 hPa sein kann. Weiterhin ist die in DE-A-3 136 895 angegebene Näherung nicht zulässig, da der Gesamtdruck der Summe von Ansprechdruck und Reaktionsdruck entspricht, wobei unter Reaktionsdruck der Druck im CVD-Reaktor zu verstehen ist. Der Reaktionsdruck liegt aber auch bei LPCVD in der Größenordnung einiger Hektopascal.

Der Erfindung liegt die Aufgabe zugrunde, ein Verfahren zu schaffen, bei welchem der Gasstrom bis zur Sättigung mit dem Dampf des wenig flüchtigen Stoffes angereichert wird, also ein hoher Massenfluß des wenig flüchtigen Stoffes erzielt wird, wobei eine Flußkonstanz über eine lange Dauer erzielt wird und so typische wirksamkeitsmindernde Erscheinungen, wie Kaminbildung, Kontaktsinterung und Verstopfung, vermieden werden.

Diese Aufgabe wird erfindungsgemäß dadurch gelöst, daß bei einem Verfahren der eingangs genannten Art

- die Querschnittsfläche des Innenraums mindestens hundertmal größer als die Querschnittsflächen von Zu- und Ableitung gewählt wird,
- eine der beiden Platten, die Gaseintrittsplatte zwischen der Mündung der Zuleitung und dem Pulver angeordnet wird,
- die andere Platte, die Gasaustrittsplatte, zwischen dem Pulver und der Mündung der Ableitung angeordnet wird,
- mindestens eine der beiden Platten bewegbar ist und bei Betrieb der Vorrichtung auf das Pulver aufgepreßt wird und
- die Dicke der Gaseintrittsplatte, die Dicke der Gasaustrittsplatte, die Porengröße der beiden Platten und der Abstand zwischen den beiden Platten bzw. die Dicke der Pulverschüttung im Innenraum derart gewählt werden, daß bei Betrieb der Vorrichtung der Druckabfall in der Gaseintrittsplatte größer als der Druckabfall in der Pulverschüttung ist, daß der Druckabfall in der Pulverschüttung sehr viel größer als der Druckabfall in der Gasaustrittsplatte ist und daß der Druckabfall in der Gasaustrittsplatte sehr viel kleiner als der Druck im Reaktor ist.

Die Dicke der Gaseintrittsplatte beträgt vorzugsweise das fünf- bis hundertfache der Dicke der Gasaustrittsplatte.

Die Porengröße der beiden Platten ist vorzugsweise mindestens um den Faktor 2 kleiner als die mittlere Korngröße der Inertkomponente des Pulvers.

Der Abstand zwischen den beiden Platten bzw. die Dicke der Pulverschüttung im Innenraum entspricht vorzugsweise höchstens der vier- bis fünffachen Dicke, insbesondere der gleichen Dicke, der Gaseintrittsplatte.

Bei Betrieb des erfindungsgemäßen Pulversättigers ist die Ableitung, d.h. die Verbindungsleitung zwischen Sättiger und Reaktor, mindestens auf die Sättigungstemperatur aufgeheizt, da sonst bei der Dampfüberführung eine teilweise Kondensation des wenig flüchtigen Stoffes in der Ableitung stattfindet.

Aus demselben Grund, d.h. wegen der Rückkondensation, muß der gesamte Sättiger einschließlich seiner Außenwände auf derselben Temperatur, nämlich der Sättigungstemperatur, gehalten werden. Bereits Temperaturunterschiede von $5\,^{\circ}C$ führen bei Verbindungen wie Th(tfa)$_4$ oder Th(fod)$_4$ oder Sc(tfa)$_3$ zu starken Dampfdruckänderungen und daher zur Rückkondensation.

Das gesamte nach außen vakuumdichte Verdampfergefäß befindet sich z.B. in einem thermostatisierten Flüssigkeitsbad, wodurch eine gleichmäßige Temperatur, die je nach zu verdampfendem Stoff zwischen 30 und $300\,^{\circ}C$ liegt, auch im Außenbereich, d.h. im Wandbereich der Pulverschüttung parallel zum Gasstrom, erzielt wird.

Bei dem erfindungsgemäßen Sättiger ist der Gesamtquerschnitt des Innenraums gegenüber dem Querschnitt von Zu- und Ableitung stark erhöht, wodurch die Strömungsgeschwindigkeit im Innenraum herabgesetzt wird.

Da, wie gesagt, wenig flüchtige Stoffe mit hinreichendem Fluß aus dem Sättiger in den Reaktor überführt werden sollen, sind die Inertgasströme in der Regel etwa 100fach größer als die Stoffströme. Zur Erzielung einer ausreichenden Sättigung müssen die hohen Inertgasgeschwindigkeiten im Sättiger mindestens entsprechend herabgesetzt werden. Das erreicht man erfindungsgemäß durch eine starke Erhöhung des Querschnitts des Innenraums, genauer der Gesamtporen-Querschnittsfläche des Sättigers, im Verhältnis zum Querschnitt des übrigen Rohrleitungssystems. Als untere Grenze für einen variablen Sättigerbetrieb bezüglich Einstellbereich der Durchsätze gilt, daß die Querschnittsfläche etwa hundertmal größer als die der genannten Leitungen ist.

Die Querschnittserweiterung im erfindungsgemäßen Sättiger beträgt demnach z.B. mindestens 40 mm (Durchmesser des Innenraums) zu 4 mm (Durchmesser der Leitungen) = 10 : 1, d.h. 100 : 1 in der Querschnittsfläche. Bei großen Gasflüssen ist ein Verhältnis von 100 : 1 (Durchmesser) bzw. 10000 : 1 (Flächen) vorteilhaft.

3

EP 0 325 319 B1

Die zusätzliche feste Inertkomponente, wie z.B. Quarzpulver, stabilisiert die Pulverschüttung und sorgt dafür, daß dem Inertgas eine sehr große Oberfläche des wenig flüchtigen Stoffes angeboten wird.

Der Innenraum ist also mit einem porösen Gemisch von pulverförmigem Stoff und z.B. Quarzpulver gefüllt, das zwar wegen seiner Porosität von etwa 40% die Herabsetzung der Strömungsgeschwindigkeit zum Teil kompensiert, wodurch aber gleichzeitig eine kleine Querdimension im einzelnen Strömungskanal erzielt wird. Man erreicht dadurch folglich eine Bündelung bzw. Parallelschaltung von sehr vielen sehr feinen Strömungskapillaren und gleichzeitig eine große Oberfläche von wenig flüchtigem Stoff.

Um eine Kanal- oder Kaminbildung in der Pulverschüttung (Maulwurfsgänge) zu vermeiden, wird über je eine poröse Metallplatte oder Fritte am Trägergaseintritt und -austritt eine gleichmäßigere Verteilung des Gasstroms über den Querschnitt des Innenraums eingestellt. Dabei ist die Bedingung einzuhalten, daß der Druckabfall über der Pulverschüttung vernachlässigbar klein ist gegen den Druckabfall über der als Gaseintrittsplatte wirkenden porösen Metallplatte.

Die poröse Platte am Gaseintritt ist dabei z.B. mindestens 10 bis 20 mm dick und hat z.B. eine Porosität von etwa 30%. Dadurch wird eine gleichmäßige Geschwindigkeitsverteilung des Inertgases über den gesamten Querschnitt des Innenraums erreicht und die stabilisierte Pulverschüttung wird optimal ausgenutzt.

Die mittleren Porengrößen der Eintrittsplatte und der Austrittsplatte müssen dabei um mindestens einen Faktor 2 bis 3 kleiner sein als die mittlere Korngröße der Inertkomponente der Schüttung (z.B. Quarzpulver). Die Dicke der Gaseintrittsplatte sollte dann das 5- bis 100fache der Dicke der Austrittsplatte betragen, vorzugsweise das 20- bis 30fache. Bei Beschichtungen mit Reaktordrücken von höchstens 10 hPa sollte die Dicke der Gasaustrittsplatte nicht über 1 mm sein.

Das Aufpressen mindestens einer der porösen Platten auf die Pulverschüttung wird z.B. durch die Schwerkraft und/oder den Gasstrom oder durch mindestens eine Feder bewirkt, so daß auch bei fortschreitendem Verdampfen keine größeren Hohlräume entstehen.

Die erfindungsgemäße Vorrichtung ist vorzugsweise bei Unterdruck betreibbar, wobei das Gefäß über die Ableitung mit einer Reaktorkammer, z.B. für CVD, verbunden ist, in der bei Betrieb der Vorrichtung ein noch niedrigerer Druck als im Gefäß herrscht.

Die Korngrößen der Inertkomponente des Pulvers liegen vorzugsweise im Bereich 20 bis 100 $\mu$m, während die Porengrößen der beiden Platten vorzugsweise im Bereich 10 bis 30 $\mu$m und die Korngrößen des wenig flüchtigen, pulverförmigen Stoffes vorzugsweise im Bereich 0,1 bis 20 $\mu$m liegen.

Der wenig flüchtige, pulverförmige Stoff ist vorzugsweise mindestens eine MOV, die bei Betrieb der Vorrichtung auf eine Temperatur nahe ihres Schmelzpunkts erhitzt ist. Als MOV werden dabei vorzugsweise organische Verbindungen der Erdalkalimetalle oder der Übergangsmetalle, insbesondere von Elementen der Scandium-Gruppe und der Seltenen Erden, eingesetzt.

Vorzugsweise sind die Zuleitung für den Gasstrom, die Gaseintrittsplatte, die Gasaustrittsplatte und die Ableitung für den angereicherten Gasstrom derart einander zugeordnet, daß der Gasstrom bei Betrieb der Vorrichtung in Schwerkraftrichtung durch die Vorrichtung strömt.

Bei einer weiteren bevorzugten Ausführungsform der Erfindung ist eine Einrichtung zur Umwälzung der Pulverschüttung vorgesehen, um eine Kaminbildung zu vermeiden. Dies kann z.B. durch einen in das Pulver eingetauchten Rührer bei nicht gepreßtem Pulver, durch einen Schneckentrieb oder durch einen Ultraschallgeber erreicht werden. Letzteres ist eine sehr elegante Lösung, da dafür keine konstruktiven Änderungen vorgenommen werden müssen. Bei Beschichtungen, deren Dauer in der Größenordnung einer Stunde liegen, bringt bereits das mechanische Umrühren (Aufstochern) des Pulvers in den Beschichtungspausen eine große Verbesserung.

Gerade bei pulverförmigen Stoffen, die im Sättiger bis kurz unterhalb ihres Schmelzpunktes (Smp) erhitzt werden, wie Th(tfa)$_4$ (Smp 134 °C), Th(fod)$_4$ (Smp 151 °C) oder Sc(tfa)$_3$ (Smp 106 °C), ist ein mechanisches Umrühren oder Aufstochern vorteilhaft. In diesen Fällen ist das dosiert zu verdampfende Pulver mit trockenem Quarzpulver im Verhältnis 1 : 2 vermischt, das zur Stabilisierung der Pulverschüttung dient. Stickstoff oder Argon dienen als Inertgas. Im CVD-Reaktor, der nach dem Sättiger geschaltet ist, herrscht ein Druck zwischen 1 und 100 hPa, vorzugsweise 5 bis 20 hPa, je nach Anwendung. Bei Trägergasflüssen bis zu 500 sccm können Massenflüsse des wenig flüchtigen Stoffes von bis zu 5 bis 10 sccm erzielt werden.

Die pulverförmige Füllung des Innenraums wird entweder in den Betriebspausen umgerührt oder aufgestochert oder während des Betriebs umgerührt oder in Bewegung gehalten, z.B. mechanisch oder durch eine Ultraschallquelle.

Bei einer weiteren bevorzugten Ausführungsform der Erfindung ist die Umwälzeinrichtung eine ein Magnetfeld erzeugende Einrichtung. In diesem Fall besteht die Inertkomponente des Pulvers aus magnetisierbaren Teilchen, z.B. aus magnetischen Eisenkugeln, die durch ein externes Magnetfeld bewegt werden,

4

oder aus magnetischen Eisenfeilspänen, die in einem Magnetfeld ausgerichtet und gegebenenfalls bewegt werden, wobei in einem inhomogenen Magnetfeld auch Strömungsfäden mit einer die Strömungsgeschwindigkeit günstig beeinflussenden Querdimension erzeugt werden.

Die Inertkomponente des Pulvers hat vorzugsweise eine sehr schmale Korngrößenverteilung, wobei die maximale Schwankungsbreite im Korndurchmesser weniger als 30% des mittleren Korndurchmessers beträgt.

Die Inertkomponente besteht z.B. aus kleinen runden Kugeln, z.B. aus Quarz oder Edelstahl, deren Durchmesser z.B. 0,5 mm beträgt.

Bei einer weiteren vorteilhaften Ausführungsform der Erfindung wird der pulverförmige Stoff - statt einer Vermischung mit pulverförmigem inertem Material - in die Zwischenräume zwischen Fäden (quergespannt, längsgespannt oder statistisch verschlungenes Gewebe) aus inertem Material eingefüllt.

Bei einer weiteren erfindungsgemäßen Ausgestaltung des Sättigers besteht der Innenraum aus parallelen getrennten Transportkanälen, z.B. aus einem Wabenkörper, in die das zu verdampfende Pulver, mit der inerten Pulverkomponente gemischt, eingefüllt ist.

Die Wirksamkeit des erfindungsgemäßen Sättigers kann dadurch beeinträchtigt werden, daß wegen des Druckabfalls über der Pulverschüttung, der nur in erster Näherung linear ist, die Strömungsgeschwindigkeit beim Eintritt in die Pulverschüttung viel geringer ist als beim Austritt in die dünne poröse Platte. Durch eine erfindungsgemäße Vergrößerung des Strömungsquerschnitts zum Gasaustritt hin wird diese Erhöhung der Strömungsgeschwindigkeit gegebenenfalls kompensiert und es wird eine noch bessere Wirksamkeit und zeitliche Flußkonstanz erreicht. Die besagte Querschnittsvergrößerung wird vorzugsweise dadurch erreicht, daß der Querschnitt des Innenraums in Richtung Gasaustritt erweitert ist, oder dadurch, daß die beiden porösen Platten und der Innenraum halbkugelförmig ausgebildet sind.

Einige Ausführungsbeispiele der Erfindung sind in einer Zeichnung dargestellt, die im folgenden näher erläutert wird. In der Zeichnung zeigen

Fig. 1 einen Pulversättiger schematisch im Längsschnitt,

Fig. 2 einen als Wabenkörper gestalteten Innenraum eines Pulversättigers schematisch im Querschnitt,

Fig. 3 einen Pulversättiger, bei dem der Querschnitt des Innenraums in Richtung Gasaustritt erweitert ist, schematisch im Längsschnitt, und

Fig. 4 einen halbkugelförmig ausgebildeten Pulversättiger schematisch im Schnitt.

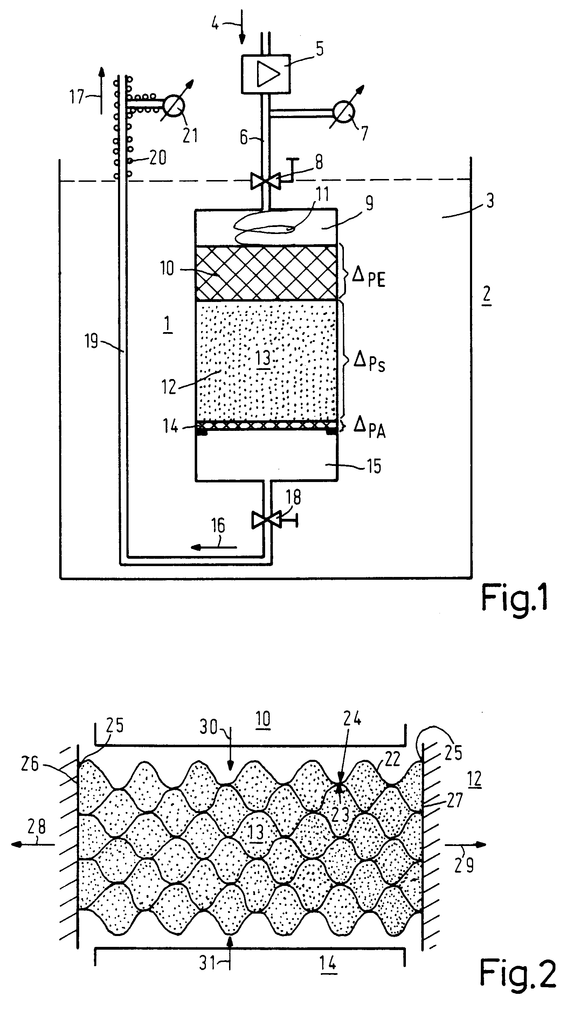

Fig. 1 zeigt ein Verdampfergefäß 1, das in einem Thermostaten 2 angeordnet ist und darin von einer Thermostat-Flüssigkeit 3 umgeben ist.

Ein durch einen Pfeil 4 angedeuteter Inertgasstrom tritt über ein Massenfluß-Regelventil 5, eine Zuleitung 6 mit einem Manometer 7 und einem Auf/Zu-Gaseinlaßventil 8 in eine Einlaßkammer 9 ein und durchströmt mit einem Druckgefälle $\Delta p_E$ eine dicke poröse Gaseintrittsplatte 10, die durch eine Feder 11 auf eine in einen Innenraum 12 eingefüllte Pulverschüttung 13, die einen zu verdampfenden wenig flüchtigen Stoff enthält, aufgepreßt wird, so daß praktisch keine größeren Hohlräume entstehen.

Die poröse Platte 10 hat die Funktion, für eine gleichmäßige Inertgas-Geschwindigkeitsverteilung über die Querdimension der Pulverschüttung 13 zu sorgen, um eine Kaminbildung zu vermeiden.

Das Inertgas durchströmt die Pulverschüttung 13 mit einem Druckgefälle $\Delta p_S$, wonach das dabei mit dem wenig flüchtigen Stoff gesättigte Inertgas mit einem Druckgefälle $\Delta p_A$ durch eine dünne poröse Gasaustrittsplatte 14 in eine Gasaustrittskammer 15 austritt. Der Gasstrom erreicht sodann, wie durch Pfeile 16 und 17 angedeutet, über ein Auf/Zu-Ventil 18 und eine auf mindestens Sättigungstemperatur geheizte Ableitung 19 mit einer Leitungsheizung 20 und einem Manometer 21 eine (nicht dargestellte) Reaktionskammer. Das Manometer 21 dient zur Messung des Drucks in der Reaktionskammer $p_{reakt}$.

An die Außenwandung des Gefäßes 1 im Bereich des Innenraums 12 ist ein Ultraschallgeber (nicht dargestellt) angesetzt, der bei längerem Betrieb die Kaminbildung verhindert, indem er das Pulver etwas in Bewegung hält. Eventuell ist es vorteilhaft, zusätzlich in den Betriebspausen zwischen zwei Beschichtungen ein mechanisches Umrühren und Aufstochern der Pulverschüttung 13 im Innenraum 12 durchzuführen. Das ist besonders dann von Vorteil, wenn der Sättiger zur Erzielung hoher Massenflüsse knapp unterhalb des Schmelzpunktes des zu verdampfenden Stoffes betrieben wird.

Die mittleren Porengrößen der Eintrittsplatte 10 und der Austrittsplatte 14 sind mindestens einen Faktor 2 bis 3 kleiner als die mittlere Korngröße der Inertkomponente der Schüttung 13 (z.B. Quarzpulver; 10 und 14 sind feinporige Fritten oder poröse Sintermetallplatten).

Die Dicke der Gaseintrittsplatte 10 beträgt, wie gesagt, das 5- bis 100fache der Dicke der Austrittsplatte 14, vorzugsweise das 20- bis 30fache. Bei Beschichtungen mit Reaktordrücken von höchstens 10 hPa beträgt die Dicke von 14 nicht über 1 mm.

Für die jeweiligen Druckabfälle $\Delta p_E$, $\Delta p_S$, $\Delta p_A$ (= $\Delta_p$ von 10, 13, 14) gilt die Druckbedingung $\Delta p_E > \Delta p_S \gg \Delta p_A$ und $\Delta p_A \ll p_{reakt}$. Das wird dann wirksam erfüllt, wenn z.B. $\Delta p_E = 2 \Delta p_S = 200 \Delta p_A$ und $\Delta p_A = 0{,}1\ p_{reakt}$. Diese Druckbedingung ist mit der zuvor angegebenen geometrischen Anforderung identisch, wie nachfolgend erläutert wird.

Wenn die jeweiligen Dicken mit $d_E$, $d_S$ und $d_A$ bezeichnet werden, so muß bei gleicher Porosität beachtet werden, daß $d_E \geq d_S \gg d_A$. Bei lockerer Schüttung im $\geq$ Sättiger kann auch $d_E < d_S$ sein, sofern die zuvor angegebene Druckbedingung eingehalten wird. Bei einer mittleren Porengröße $\delta_A$ in Platte 14 und $\delta_E$ in Platte 10 von jeweils $20\mu m$ und einer mittleren Korngröße $\delta_S$ des Quarzpulvers von $50\mu m$ ($50\mu m \pm 20\mu m$ Verteilung) führen die Dicken $d_E \approx d_S \geq 40\ d_A$ oder auch schon $d_E = 0{,}5\ d_S \geq 20\ d_A$ zu einem wirksamen Sättiger. Die Relation

$$d_S/v_{Tr} > \delta_S/v_{d,B} \qquad (1)$$

wobei $v_{Tr}$ die Strömungsgeschwindigkeit des Inertgases und $v_{d,B}$ die Verdampfungsgeschwindigkeit eines wenig flüchtigen Stoffes B bedeuten, ist eine Bedingung für die zeitliche Flußkonstanz des Sättigers.

Da wie gesagt wenig flüchtige Stoffe aus dem Sättiger mit noch hinreichendem Fluß in den Reaktor überführt werden sollen, sind die Inertgasströme in der Regel etwa 100fach größer als die Stoffströme. Zur Erzielung einer ausreichenden Sättigung müssen die hohen Inertgasgeschwindigkeiten im Sättiger mindestens entsprechend herabgesetzt werden. Das erreicht man wie gesagt durch eine starke Erhöhung des Rohrquerschnitts, genauer der Gesamtporen-Querschnittsfläche des Sättigers $F_{S,eff}$, im Verhältnis zum Querschnitt $F_{rohr}$ des übrigen Rohrleitungssystems. $F_{S,eff}$ ist $F_S \cdot \eta_p$, wobei $\eta_p$ die Porosität der Pulverschüttung angibt. Als untere Grenze für einen variablen Sättigerbetrieb bezüglich Einstellbereich der Durchsätze gilt $F_{S,eff} \gg 100\ F_{rohr}$, wobei $p_{reakt}$ etwa im Bereich 10 hPa liegt.

Im allgemeinen soll die Bedingung

$$F_{S,eff}/F_{rohr} \geq p_o/p_{reakt} \qquad (2)$$

eingehalten werden, mit $p_{reak} < p_o = 1000$ hPa.

In der Regel genügt es, die Faustregel

$F_S/F_{rohr} \approx p_o/P_{reakt}$ anzuwenden.

Nun muß jedoch noch eine weitere Randbedingung für die geometrischen Abmessungen des Sättigers erfüllt sein. Es sollen kurze Querdiffusionswege vorliegen, d.h. die Zeit für die Querdiffusion von der jeweiligen Abdampfungsoberfläche in einen Stromfaden soll kürzer sein als die gesamte Durchströmungszeit durch den Innenraum durch diesen Stromfaden. Nur so kann eine ausreichende Sättigung erzielt werden. Als Voraussetzung dafür gilt, daß die Verdampfungsgeschwindigkeit von der Oberfläche größer als die Diffusionsgeschwindigkeit ist, denn anderenfalls würde die Formel (1) gelten. Die erfindungsgemäße weitere Bedingung lautet

$$\delta_S^2/4D \leq d_S/v_{Tr} \qquad (3)$$

wobei D die Diffusionskonstante ist.

Zur Überprüfung im konkreten Beispiel sollen im folgenden die typischen Werte der einzelnen Größen für den Sättiger ermittelt werden. Aus der Formel

$$v_{d,B} = f \cdot \sqrt{R_o T/2\pi M} \qquad (4)$$

in der f der Verdampfungskoeffizient, $R_o$ = $62{,}364.10^3.1{,}33$ hPa.cm$^3$/K, d.h. die Gaskonstante, T die Temperatur des Stoffes B und M das Molekulargewicht des Stoffes B bedeuten, folgt mit T = 400 K, M = 1412 für B = Th(fod)$_4$ und f = 1 als Verdampfungsgeschwindigkeit $v_{d,B} \approx 2000$ cm/s. Für den bei der anschließenden Diffusionsbewegung im Mittel in der Zeit t zurückgelegten Weg $\bar{x}$ gilt auch für die Querkomponente

$$\bar{x} = \sqrt{Dt} \qquad (5).$$

Nach einer von F. Weling in ISPC 7, Eindhoven 1985, S. 165 bis 170, angegebenen Näherungsformel können bei $T_S$ = 400 K und $p_S$ = 50 hPa für $B_1$ = Th(fod)$_4$, $B_2$ = Th(tfa)$_4$ und $B_3$ = Sc(tfa)$_3$ die Diffusionskonstanten zu $D_1$ = 0,43 cm$^2$/s, $D_2$ = 0,5 cm$^2$/s und $D_3$ = 0,85 cm$^2$/s berechnet werden. Die Diffusionskonstanten im Sättiger bei Betrieb liegen also zwischen 0,2 und 1 cm$^2$/s für p ≈ 50 hPa und zwischen 1 und 5 cm$^2$/s für $p_S$ ≈ 10 hPa. Es ist daher von D ~1 cm$^2$/s auszugehen. Die Diffusionsgeschwindigkeit $v_{diff}$ = $\overline{x}/t$ = $\sqrt{D/t}$ liegt damit in der Größenordnung 1 cm/s und ist somit wesentlich geringer als die Verdampfungsgeschwindigkeit, so daß $v_{diff}$ die limitierende Größe ist. Erst ab f < $10^{-3}$ übernimmt $v_{d,B}$ allmählich die limitierende Rolle.

Liegt bei der inerten Pulverkomponente z.B. eine Korngrößenverteilung $\delta_{S,min}$ ≤ $\delta_S$ ≤ $\delta_{S,max}$ vor, so sind in der Regel die kleineren Durchmesser maßgebend.

Setzt man eine mittlere Inertkorngröße von 50 $\mu$m in $\delta_S^2/4D$ ein, so ergibt sich als Größenordnung für die Zeit der Querbewegung etwa 3.10$^{-5}$s. Für $Q_{Tr}$ = 500 sccm, $p_S$ = 10 hPa, $\eta_p$ = 0,3 und $F_s$ = 4$\pi$ cm$^2$ folgt nun $v_{Tr}$ = $v_{Ar}$ ≈ 300 cm/s und damit $d_S/v_{Ar}$ ≈ 10$^{-2}$s, so daß Bedingung (3) gut erfüllt ist. Auch die erfindungsgemäße allgemeine Konstruktionsregel für Niederdruckverdampfer mit MOV

$$\delta_S^2 \leq d_S/100 \qquad (6)$$

mit $\delta_S$ und $d_S$ in cm wird damit gut erfüllt.

Fig. 2 zeigt einen Innenraum 12 aus parallelen getrennten Transportkanälen, der aus einem Wellblech-Wabenkörper besteht, in die das zu verdampfende Pulver mit einer inerten Pulverkomponente gemischt eingefüllt ist.

Zur Herstellung des Wabenkörpers werden sinusförmig gewellte Bleche 22 aus einem inerten Material, mit dem der später einzufüllende verdampfende Stoff nicht reagiert (für viele Anwendungszwecke können z.B. Edelstahlwellbleche, Tantal oder Molybdän-Bleche verwendet werden), jeweils um 90° versetzt mit den jeweiligen "Maxima" 23 und "Minima" 24 aufeinander verschweißt, so daß sich eine lineare Wabenstruktur ergibt.

Die Außenkanten 25 dieser Bleche sind auf beiden Seiten jeweils in eine feste Wand 26, 27 dicht eingeschweißt bzw. festgeklemmt und verschraubt. Senkrecht zur Schnittebene befinden sich oberhalb und unterhalb dieser Lamellenstruktur eine passende, dicht abschließende und abnehmbare dicke poröse Platte 10 am Gaseintritt und eine entsprechende dünnere Platte 14 am Gasaustritt. Die Pulverschüttung 13 im Innern der einzelnen Lamellen wird durch Auseinanderziehen der Wände 26 und 27 (Pfeile 28 und 29) und/oder durch Druck bzw. Pressen der Platten 10 und 14 (Pfeile 30 und 31) dicht gehalten und die Ausbildung von Kaminen bzw. Maulwurfsgängen in der Schüttung wird vermieden. Eingefüllt wird der pulverförmige wenig flüchtige Stoff durch Abnahme z.B. der porösen Gaseintrittsplatte 10 von oben. Die Betriebslage des Innenraums nach dem Verschließen des Gefäßes ist beliebig, sie kann senkrecht, aber auch waagerecht sein. Der große Vorteil eines solchen Sättigers ist die Verhinderung von breiten Kaminen mit geringem Strömungswiderstand. Eine vorteilhafte Variante ist, einen Teil der Lamellen in der einen Richtung und einen Teil in der Gegenrichtung durchströmen zu lassen, mit entsprechend dichter Abtrennung am Lamelleneintritt und Lamellenaustritt (Prinzip der Kaskadenschaltung).

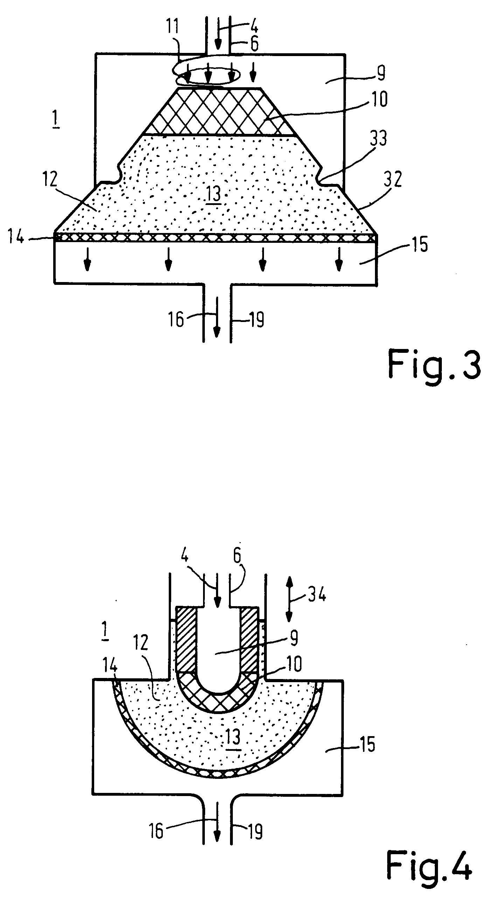

Zu Fig. 3 sei einleitend bemerkt, daß der Wirkungsgrad eines Sättigers auch dadurch beeinträchtigt werden kann, daß wegen des Druckabfalls $\Delta p_S$ über der Schüttung, der nur in erster Näherung linear ist, die Strömungsgeschwindigkeit beim Eintritt mit dem Druck $P_{reakt}$ + $\Delta p_A$ + $\Delta p_S$ viel geringer ist als beim Austritt in die dünne poröse Platte mit dem Druck an der Grenzfläche $\Delta p_A$ + $p_{reakt}$. Durch die erfindungsgemäße Erweiterung des Sättigerquerschnitts zum Gasaustritt hin kann diese Erhöhung der Strömungsgeschwindigkeit kompensiert werden und es wird eine noch bessere Wirksamkeit und zeitliche Flußkonstanz erreicht. Ein solcher Sättiger ist in Fig. 3 dargestellt, in der die Bezugszeichen dieselbe Bedeutung wie in Fig. 1 haben.

Zusätzlich zu der Querschnittserweiterung in Richtung Gasaustritt ist die undurchlässige Wand 32 des Gefäßes 1, z.B. aus biegsamem Blech, an mindestens einer Stelle mit einer Wellbalgausgleichszone ringförmig versehen, so daß bei einer Pressung durch die Feder 11 von oben die Schüttung 13 dicht, d.h. ohne die Bildung von größeren Hohlräumen, bleibt.

Fig. 4, in der die Bezugszeichen dieselbe Bedeutung wie in Fig. 1 und 3 haben, zeigt einen halbkugelförmig ausgebildeten Sättiger.

Die Schüttungspressung wird dabei durch eine Art Stößel mit einer Gaseintrittskammer 9 und einer halbrunden porösen Gaseintrittsplatte 10 erreicht, der von oben auf eine Pulverschüttung 13 aufgepreßt wird, was durch einen Doppelpfeil 34 angedeutet ist. Durch eine dünne poröse Austritts-Halbkugelkalotte 14 tritt gesättigtes Inertgas in eine Gasaustrittskammer 15 aus und strömt von dort weiter zu einem Reaktor. Der Vorteil einer solchen Anordnung ist, daß die Strömungsgeschwindigkeit im einzelnen Faden wegen der integralen Querschnittsvergrößerung in etwa konstant bleibt und die Querdiffusion am Austritt größer ist, was einen niedrigeren Effektivdruck $p_{S,eff}$ im Sättiger und damit einen höheren Massentransport bedeutet.

**Patentansprüche**

1. Verfahren zum Erzeugen eines mit dem Dampf mindestens eines wenig flüchtigen, in Pulverform vorliegenden Stoffes angereicherten, aus mindestens einem Inertgas bestehenden Gasstroms, unter Verwendung einer Vorrichtung
   - mit einem Gefäß mit einem Innenraum zur Aufnahme des Pulvers,
   - einer Zuleitung für den Gasstrom und
   - einer Ableitung für den angereicherten Gasstrom in einen Beschichtungs-Reaktor, in welchem ein niedrigerer Druck als im Gefäß herrscht,
   - wobei in der Zuleitung und in der Ableitung je ein Ventil angeordnet ist,
   - die Leitungen derart in das Gefäß münden, daß der Gasstrom bei Betrieb der Vorrichtung durch das Pulver hindurchströmt,
   - das Gefäß und die Ableitung in einem Thermostaten angeordnet sind,
   - das Pulver eine zusätzliche feste Inertkomponente enthält und
   - der Innenraum zwei quer zum Gasstrom angeordnete Wände aus gasdurchlässigen, porösen Platten aufweist, während die übrigen Wände des Innenraums gasundurch lässig sind,
   dadurch gekennzeichnet, daß
   - die Querschnittsfläche des Innenraums (12) mindestens hundertmal größer als die Querschnittsflächen von Zu- und Ableitung (6,19) gewählt wird,
   - eine der beiden Platten, die Gaseintrittsplatte (10) zwischen der Mündung der Zuleitung (6) und dem Pulver (13) angeordnet wird,
   - die andere Platte, die Gasaustrittsplatte (14), zwischen dem Pulver (13) und der Mündung der Ableitung (19) angeordnet wird,
   - mindestens eine der beiden Platten bewegbar ist und bei Betrieb der Vorrichtung auf das Pulver (13) aufgepreßt wird,
   - mindestens eine der beiden Platten bewegbar ist und bei Betrieb der Vorrichtung auf das Pulver (13) aufgepreßt wird und
   - die Dicke der Gaseintrittsplatte (10), die Dicke der Gasaustrittsplatte (14), die Porengröße der beiden Platten (10,14) und der Abstand zwischen den beiden Platten (10,14) bzw. die Dicke der Pulverschüttung (13) im Innenraum (12) derart gewählt werden, daß bei Betrieb der Vorrichtung der Druckabfall in der Gaseintrittsplatte (10) größer als der Druckabfall in der Pulverschüttung (13) ist, daß der Druckabfall in der Pulverschüttung (13) sehr viel größer als der Druckabfall in der Gasaustrittsplatte (14) ist und daß der Druckabfall in der Gasaustrittsplatte (14) sehr viel kleiner als der Druck im Reaktor ist.

2. Verfahren nach Anspruch 1,
   dadurch gekennzeichnet, daß die Dicke der Gaseintrittsplatte (10) das fünf- bis hundertfache der Dicke der Gasaustrittsplatte (14) beträgt.

3. Verfahren nach Anspruch 1 oder 2,
   dadurch gekennzeichnet, daß die Porengröße der beiden Platten (10,14) mindestens um den Faktor 2 kleiner als die mittlere Korngröße der Inertkomonente des Pulvers (13) ist.

4. Verfahren nach Anspruch 1,2 oder 3,
   dadurch gekennzeichnet, daß der Abstand zwischen den beiden Platten (10,14) bzw. die Dicke der Pulverschüttung (13) im Innenraum (12) höchstens der fünffachen Dicke der Gaseintrittsplatte (10) entspricht.

5. Verfahren nach Anspruch 4,
   dadurch gekennzeichnet, daß der Abstand zwischen den beiden Platten (10,14) bzw. die Dicke der Pulverschüttung (13) im Innenraum (12) der Dicke der Gaseintrittsplatte (10) entspricht.

6. Verfahren nach Anspruch 1 oder 3,
   dadurch gekennzeichnet, daß die Korngrößen der Inertkomponente des Pulvers (13) im Bereich 20 bis 100 $\mu$m, die Porengrößen der beiden Platten (10,14) im Bereich 10 bis 30 $\mu$m und die Korngrößen des wenig flüchtigen, pulverförmigen Stoffes im Bereich 0,1 bis 20 $\mu$m liegen.

7. Verfahren nach Anspruch 1 oder 6,
dadurch gekennzeichnet, daß der wenig flüchtige, pulverförmige Stoff mindestens eine metallorganische Verbindung ist, die bei Betrieb der Vorrichtung auf eine Temperatur nahe ihres Schmelzpunkts erhitzt wird.

8. Verfahren nach Anspruch 7,
dadurch gekennzeichnet, daß der wenig flüchtige, pulverförmige Stoff eine organische Verbindung der Erdalkalimetalle oder der Übergangsmetalle ist.

9. Verfahren nach Anspruch 8,
dadurch gekennzeichnet, daß der wenig flüchtige, pulverförmige Stoff eine metallorganische Verbindung mit Elementen der Scandiumgruppe oder der Seltenen Erden ist.

10. Verfahren nach Anspruch 1,2,3 oder 4,
dadurch gekennzeichnet, daß die Zuleitung (6) für den Gasstrom, die Gaseintrittsplatte (10), die Gasaustrittsplatte (14) und die Ableitung (19) für den angereicherten Gasstrom derart einander zugeordnet sind, daß der Gasstrom (4,16) bei Betrieb der Vorrichtung in Schwerkraftrichtung durch die Vorrichtung strömt.

11. Verfahren nach Anspruch 2 oder 10,
dadurch gekennzeichnet, daß die Dicke der Gaseintrittsplatte (10) das 20- bis 30- fache der Dicke der Gasaustrittsplatte (14) beträgt.

12. Verfahren nach Anspruch 1,10 oder 11,
gekennzeichnet durch, die Verwendung einer Einrichtung zum Umwälzen der Pulverschüttung (13).

13. Verfahren nach Anspruch 12,
dadurch gekennzeichnet, daß die Umwälzeinrichtung eine ein Magnetfeld erzeugende Einrichtung ist und die Inertkomponente des Pulvers (13) aus magnetisierbaren Teilchen besteht.

14. Verfahren nach Anspruch 1 oder 3,
dadurch gekennzeichnet, daß die Inertkomponente des Pulvers (13) eine schmale Korngrößenverteilung hat, wobei die maximale Schwankungsbreite des Korndurchmessers weniger als 30% des mittleren Korndurchmessers beträgt.

15. Verfahren nach Anspruch 1,
dadurch gekennzeichnet, daß die Inertkomponente aus Fäden aus inertem Material besteht, die im Innenraum (12) aufgespannt werden.

16. Verfahren nach Anspruch 1, 10, oder 11,
dadurch gekennzeichnet, daß der Innenraum (12) aus parallelen getrennten Transportkanälen besteht.

17. Verfahren nach Anspruch 1, 10 oder 11,
dadurch gekennzeichnet, daß sich der effektive Strömungsquerschnitt zur Ausströmseite hin vergrößert.

18. Verfahren nach Anspruch 17,
dadurch gekennzeichnet, daß der Querschnitt des Innenraums (12) in Richtung Gasaustritt (15) erweitert ist.

19. Verfahren nach Anspruch 17,
dadurch gekennzeichnet, daß die beiden porösen Platten (10,14) und der Innenraum (12) halbkugelförmig ausgebildet sind.

9

**Claims**

1. A method of producing a gas flow which consists of at least one inert gas and which is enriched with the vapour of a difficultly volatile, pulverulent substance, for which purpose the arrangement is used
   - comprising a vessel having an inner space for holding the powder,
   - a feed pipe for the gas flow and
   - a discharge pipe for conveying the enriched gas flow to a coating reactor in which the pressure is lower than in the vessel,
   - the feed and discharge pipes each having a valve and
   - the pipes opening into the vessel in such a manner that when the device is operative, the gas flows through the powder,
   - the vessel and the discharge pipe being provided in a thermostat,
   - the powder comprising an additional solid inert component,
   - the interior of the vessel having two walls which are arranged transversely to the gas flow and which are formed by gas-permeable, porous plates, whilst the other walls of the interior are impermeable to gas, characterized in that,
   - the cross-sectional area of the interior (12) space is at least a hundred times larger than the cross-sectional area of the feed and discharge pipes (6, 19),
   - one of the two plates, the gas inlet plate (10), is arranged between the mouth of the feed pipe (6) and the powder (13),
   - the other plate, the gas outlet plate (14) is arranged between the powder (13) and the mouth of the discharge pipe (19),
   - at least one of the two plates can be moved in such a manner that, during operation of the arrangement, it is pressed onto the powder (13), and
   - the thickness of the gas inlet plate (10), the thickness of the gas outlet plate (14), the pore size of the two plates (10, 14) and the spacing between the two plates (10, 14) or the thickness of the powder bed (13), in the interior (12) are chosen such that, during operation of the arrangement, the pressure drop in the gas inlet plate (10) exceeds the pressure drop in the powder bed (13), that the pressure drop in the powder bed (13) is much higher than the pressure drop in the gas outlet plate (14) and that the pressure drop in the gas outlet p]ate (14) is much smaller than the pressure in the reactor.

2. A method as claimed in Claim 1, characterized in that the thickness of the gas inlet plate (10) is five to a hundred times the thickness of the gas outlet plate (14).

3. A method as claimed in Claim 1 or 2, characterized in that the pore size of the plates (13, 14) is at least a factor of 2 smaller than the average particle size of the inert component of the powder(13).

4. A method as claimed in Claim 1, 2 or 3, characterized in that the distance between the two plaltes (10, 14) or the thickness of the powder bed (13) in the interior (12) is maximally five times the thickness of the gas inlet plate (10).

5. A method as claimed in Claim 4, charac terized in that the distance between the two plates (10, 14) or the thickness of the powder bed (13) in the interior (12) corresponds to the thickness ofl the gas inlet plate (10).

6. An method as claimed in Claim 1 or 3, characterized in that the particle sizes of the inert component of the powder (13) are in the range from 20 to 100$\mu$m, the pore sizes of the two plates (10, 14) are in the range from 10 to 30$\mu$m and the particle sizes of the difficultly volatile, pulverulent material are in the range from 0.1 to 20$\mu$m.

7. A method as claimed in Claim 1 or 6, characterized in that the difficultly volatile, pulverulent material is at least a metal-organic compound which, during operation of the arrangement, is heated to a temperature near its melting point.

8. A method as claimed in Claim 7, characterized in that the difficultly volatile, pulverulent material is an organic compound of alkaline earth metals or transition metals.

**9.** A method as claimed in Claim 8, characterized in that the difficultly volatile, pulverulent material is a metal-organic compound containing elements of the scandium group or of the rare earths.

**10.** A method as claimed in Claim 1, 2, 3 or 4, characterized in that the feed pipe (6) for the gas flow, the gas inlet plate (10), the gas outlet plate (14) and the discharge pipe (19) for the enriched gas flow are so arranged relative to each other that, during operation of the arrangement, the gas flow (4, 16) flows through the arrangement in the direction of the gravitational force.

**11.** A method as claimed in Claim 2 or 10, characterized in that the thickness of the gas-inlet plate (10) is 20 to 30 times the thickness of the gas outlet plate (14).

**12.** A method as claimed in Claim 1, 10 or 11, characterized by the use of a device for stirring the powder bed (13).

**13.** A method as claimed in Claim 12, characterized in that the stirring device is a device generating a magnetic field and the inert component of the powder (13) consists of magnetizable particles.

**14.** A method as claimed in Claim 1 or 3, characterized in that the inert component of the powder (13) has a particle size distribution within narrow limits, the maximum variation of the particle diameter being less than 30% of the average particle diameter.

**15.** A method as claimed in Claim 1, chdracterized in that the inert component is formed by filaments of an inert material, which are stretched in the interior (12).

**16.** A method as claimed in Claim 1, 10, or 11, characterized in that the interior (12) consists of parallel, separate conveyor channels.

**17.** A method as claimed in Claim 1, 10 or 11, characterized in that the effective flow cross-section widens towards the discharge side.

**18.** A method as claimed in Claim 17, characterized in that the cross-section of the interior (12) is widened towards the gas outlet (15).

**19.** A method as claimed in Claim 17, characterized in that the two porous plates (10, 14) and the interior (12) are of a semi-spherical shape.

**Revendications**

**1.** Procédé pour produire un flux de gaz enrichi de la vapeur d'au moins une substance pulvérulente peu volatile constituée au moins d'un gaz inerte, en utilisant un dispositif qui comporte:
- un récipient présentant une enceinte pour la réception de la poudre;
- un tuyau d'admission du flux de gaz et
- un tuyau d'évacuation du flux de gaz enrichi vers un réacteur de dépôt dans lequel la pression est inférieure à celle du récipient,
- le tuyau d'admission et le tuyau d'évacuation étant chacun munis d'une soupape,
- les tuyaux s'embouchant dans le récipient de manière que le flux de gaz traverse la poudre lorsque le dispositif fonctionne,
- le récipient et le tuyau d'évacuation étant disposés dans un thermostat,
- la poudre renfermant un constituant inerte solide supplémentaire et
- l'enceinte présentant deux parois constituées de plaques poreuses perméables au gaz et disposées transversalement au flux de gaz, alors que les autres parois de l'enceinte sont imperméables au gaz,
caractérisé en ce que
- l'aire de section de l'enceinte (12) est choisie au moins cent fois plus large que les aires de section du tuyau d'admission et du tuyau d'évacuation (6, 19),
- l'une des deux plaques, la plaque d'admission de gaz (10), est disposée entre la bouche du tuyau d'admission (6) et la poudre (13),

- l'autre plaque, la plaque de sortie de gaz (14), est disposée entre la poudre (13) et la bouche du tuyau d'évacuation (19),
- au moins l'une des deux plaques est amovible de manière que, lorsque le dispositif fonctionne, celle-ci est pressée sur la poudre (13),
- l'épaisseur de la plaque d'admission de gaz (10), l'épaisseur de la plaque de sortie de gaz (14), la taille de port des deux plaques (10, 14) et l'écartement entre les deux plaques (10, 14) respectivement l'épaisseur de la couche de poudre (13), dans l'enceinte (12) sont choisis de manière que lorsque le dispositif fonctionne, la chute de pression dans la plaque d'admission de gaz (10) est supérieure à la chute de pression dans la couche de poudre (13), que la chute de pression dans la couche de poudre (13) est beaucoup plus élevée que la chute de pression dans la plaque de sortie de gaz (14) et que la chute de pression dans la plaque de sortie de gaz (14) est beaucoup plus faible que la pression dans le réacteur.

2. Procédé selon la revendication 1, caractérisé en ce que l'épaisseur de la plaque d'admission de gaz (10) est comprise entre cinq et cent fois l'épaisseur de la plaque de sortie de gaz (14).

3. Procédé selon la revendication 1 ou 2, caractérisé en ce que la taille de pore moyenne des deux plaques (10, 14) est au moins inférieure d'un facteur 2 à la grosseur de grain moyenne du constituant inerte de la poudre (13).

4. Procédé selon la revendication 1, 2 ou 3, caractérisé en ce que l'écartement entre les deux plaques (10, 14) respectivement l'épaisseur de la couche de poudre (13) dans l'enceinte (12) est tout au plus égale à cinq fois l'épaisseur de la plaque d'entrée de gaz (10).

5. Procédé selon la revendication 4, caractérisé en ce que l'écartement entre les deux plaques (10, 14) respectivement l'épaisseur de la couche de poudre (13) dans l'enceinte (12) est égale à l'épaisseur de la plaque d'entrée de gaz (10).

6. Procédé selon la revendication 1 ou 3, caractérisé en ce que les grosseurs de grain du constituant inerte de la poudre (13) sont situées dans la gamme comprise entre 20 et 100 $\mu$m, que les tailles de pore des deux plaques (10, 14) sont situées dans la gamme comprise entre 10 et 30 $\mu$m et que les grosseurs de grain de la substance pulvérulente peu volatile sont situées dans la gamme comprise entre 0,1 et 20 $\mu$m.

7. Procédé selon la revendication 1 ou 6, caractérisé en ce que la substance pulvérulente peu volatile est au moins un composé organométaillque qui lors du fonctionnement du dispositif est chauffée à une température qui se situe près de son point de fusion.

8. Procédé selon la revendication 7, caractérisé en ce que la substance pulvérulente peu volatile est un composé organique des métaux alcalino-terreux ou des métaux transitoires.

9. Procédé selon la revendication 8, caractérisé en ce que la substance pulvérulente peu volatile est un composé organométallique comportant des éléments du groupe de scandium ou des terres rares.

10. Procédé selon la revendication 1, 2, 3 ou 4, caractérisé en ce que le tuyau d'admission (6) pour le flux de gaz, la plaque d'entrée de gaz (10), la plaque de sortie de gaz (14) et le tuyau d'évacuation (19) pour le flux de gaz enrichi sont mutuellement disposés de manière que, lorsque le dispositif fonctionne, le flux de gaz (4, 16) traverse ledit dispositif dans le sens du pesanteur.

11. Procédé selon la revendication 2 ou 10, caractérisé en ce que l'épaisseur de la plaque d'admission de gaz (10) est comprise entre 20 et 30 fois l'épaisseur de la plaque de sortie de gaz (14).

12. Procédé selon la revendication 1, 10 ou 11, caractérisé par l'utilisation d'un dispositif conçu pour le remuage de la couche de poudre (13).

13. Procédé selon la revendication 12, caractérisé en ce que le dispositif de remuage est un dispositif qui engendre un champ magnétique et que le constituant inerte de la poudre (13) est constitué de particules magnétisables.

12

**14.** Procédé selon la revendication 1 ou 3, caractérisé en ce que le constituant inerte de la poudre (13) présente une répartition granulométrique étroite, la largeur de fluctuation maximale du diamètre de grain étant inférieure à 30% du diamètre de grain moyen.

**15.** Procédé selon la revendication 1, caractérisé en ce que le constituant inerte est constitué de fils en matériau inerte qui sont tendus dans l'enceinte (12).

**16.** Procédé selon la revendication 1, 10 ou 11, caractérisé a ce que l'enceinte (12) est constitué de canaux de transport séparés parallèles.

**17.** Procédé selon la revendication 1, 10 ou 11, caractérisé en ce que la section d'écoulement efficace va en s'élargissant vers le côté d'évacuation.

**18.** Procédé selon la revendication 17, caractérisé en ce que la section transversale de l'enceinte (12) est agrandie dans le sens de la sortie de gaz (15).

**19.** Procédé selon la revendication 17, caractérisé en ce que les deux plaques poreuses (10, 14) et l'enceinte (12) sont conçues de façon demi-sphérique.

Fig.1

Fig.2

EP 0 325 319 B1

Fig.3

Fig.4

15